(19) Europäisches Patentamt
European Patent Office
Office européen des brevets

(11) EP 1 039 628 B1

(12) **FASCICULE DE BREVET EUROPEEN**

(45) Date de publication et mention de la délivrance du brevet:
**31.08.2005 Bulletin 2005/35**

(51) Int Cl.[7]: **H03C 3/40**, H04L 27/20

(21) Numéro de dépôt: **00460019.3**

(22) Date de dépôt: **02.03.2000**

(54) **Emetteur radiofréquence à fort degré d'intégration et avec annulation d'image, éventuellement auto-calibrée**

Hochintegrierter Hochfrequenzsender mit Beseitigung der Spiegelfrequenz, gegebenenfalls autokalibriert

Highly integrated radio frequency transmitter with image rejection, optionally auto-calibrated

(84) Etats contractants désignés:
**DE FI GB IT NL SE**

(30) Priorité: **23.03.1999 FR 9903768**

(43) Date de publication de la demande:
**27.09.2000 Bulletin 2000/39**

(73) Titulaire: **FRANCE TELECOM**
**75015 Paris (FR)**

(72) Inventeur: **Andre, M. Eric**
**38000 Grenoble (FR)**

(74) Mandataire: **Vidon, Patrice**
**Cabinet Vidon**
**16 B, rue Jouanet - B.P. 90333**
**Technopole Atalante**
**35703 Rennes Cedex 7 (FR)**

(56) Documents cités:
**EP-A- 0 692 867**
**WO-A-98/11665**
**US-A- 5 351 016**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 1 039 628 B1

Printed by Jouve, 75001 PARIS (FR)

## Description

Le domaine de l'invention est celui de la transmission de signaux par voie hertzienne.

On rappelle que l'émission d'un signal par voie hertzienne fait de plus en plus souvent appel à la modulation numérique, dont le principal avantage est de permettre l'utilisation d'algorithmes de traitement du signal. Ces derniers ont pour but d'augmenter la robustesse du signal à émettre vis-à-vis du canal de propagation.

Plus précisément, l'invention concerne un émetteur radiofréquence du type alimenté par deux signaux (ou composantes) en bande de base et en quadrature, i(t) et q(t), qui sont des images de deux flux binaires représentant une information à transmettre. En effet, quel que soit le type de modulation numérique, le signal à émettre m(t) peut s'écrire : $m(t) = i(t).\cos(\omega t) - q(t).\sin(\omega t)$, avec $\omega$ (= $2\pi f$) la fréquence d'émission du signal (aussi appelée fréquence porteuse).

On connaît, dans l'état de la technique, différents types d'émetteur radiofréquence, basés chacun sur une architecture distincte. Les plus connus sont l'émetteur radiofréquence à transposition de fréquence, l'émetteur radiofréquence à conversion directe et l'émetteur radiofréquence à boucle à verrouillage de phase. Leurs inconvénients respectifs sont maintenant discutés.

L'émetteur radiofréquence à transposition de fréquence, qui permet une transposition à une fréquence intermédiaire FI, nécessite l'utilisation de filtres passe-bande sélectifs, afin de rejeter la fréquence image à celle du signal utile à émettre. Ce premier type d'émetteur radiofréquence offre de bonnes performances, grâce à une transposition en fréquence dans le domaine numérique. En revanche, la nécessité d'utiliser des filtres performants limite son degré d'intégration sur silicium.

L'émetteur radiofréquence à conversion directe présente l'architecture la plus simple et offre un niveau d'intégration élevé. Son point faible est sa grande sensibilité aux performances des éléments qui le composent. Notamment, il convient d'éviter toute fuite de l'oscillateur local via le mélangeur, ou encore d'assurer une parfaite quadrature des signaux en sinus et cosinus. Or, ces impératifs sont souvent difficiles à respecter.

L'émetteur radiofréquence à boucle à verrouillage de phase présente de nombreux avantages, dont le fait de s'affranchir de filtres RF grâce à la caractéristique passe-bande de la boucle à verrouillage de phase (ou PLL, pour "Phase Lock Loop" en anglais). La nécessité d'avoir des signaux strictement en quadrature est également évitée. Toutefois, ces résultats ne sont possibles que si l'oscillateur contrôlé en tension (ou VCO, pour "Voltage Controlled Oscillator" en anglais) compris dans la PLL présente des performances élevées. Or, ceci n'est pas encore le cas des VCO intégrés. Par conséquent, l'émetteur radiofréquence à PLL ne permet pas d'offrir un niveau d'intégration élevé.

D'une manière générale, ces trois types d'architecture connus présentent donc un nécessaire compromis entre intégration, consommation et complexité. En d'autres termes, aucune de ces trois solutions connues n'est entièrement satisfaisante.

Le document EP 0692867 décrit un émetteur radiofréquence avec deux étages. Le premier étage comprend un traitment numérique en bande de base et en quadrature. Le deuxième étage comprend une transposition en fréquence, effectuée dans le domaine analogique de façon à générer un signal résultant modulé.

L'invention a notamment pour objectif de pallier ces différents inconvénients de l'état de la technique.

Plus précisément, l'un des objectifs de la présente invention est de fournir un émetteur radiofréquence offrant une bonne précision et présentant un très fort degré d'intégration sur silicium.

L'invention a également pour objectif de fournir un tel émetteur radiofréquence présentant une très faible sensibilité aux imperfections des éléments qui le composent.

Un autre objectif de l'invention est de fournir un tel émetteur radiofréquence permettant d'éviter une dégradation du signal utile.

Un objectif complémentaire de l'invention est de fournir un tel émetteur radiofréquence qui soit simple et présente un faible surplus de complexité par rapport aux architectures connues.

L'invention a également pour objectif de fournir un tel émetteur radiofréquence permettant de générer un signal résultant présentant une fréquence image suffisamment faible pour pouvoir être supprimée avec un filtre aux contraintes relâchées (ce filtre pouvant donc être éventuellement intégré).

Dans une variante de réalisation, l'invention a également pour objectif de fournir un tel émetteur radiofréquence ne présentant pas de fréquence image, la fréquence image en sortie étant complètement atténuée, de façon automatique, grâce à un système d'auto-calibrage et de compensation des imperfections en gain et en phase.

Ces différents objectifs, ainsi que d'autres qui apparaîtront par la suite, sont atteints selon l'invention à l'aide d'un émetteur radiofréquence, du type alimenté par deux signaux numériques en bande de base et en quadrature, i (nT) et q(nT), qui sont des images de deux flux binaires représentant une information à transmettre, l'émetteur radiofréquence comprenant :

- des moyens de transposition en fréquence intermédiaire et de traitement numérique, assurant une première transposition en fréquence effectuée dans le domaine numérique, à une fréquence intermédiaire $\omega_0$, desdits signaux

en bande de base, et générant, par combinaison, deux signaux à la fréquence intermédiaire et en quadrature ;

- des moyens de conversion directe, assurant une seconde transposition en fréquence effectuée dans le domaine analogique, par multiplication par une fréquence $\omega_1$, suivi d'une sommation, desdits deux signaux à la fréquence intermédiaire et en quadrature, de façon à générer un signal résultant qui se trouve au final modulé autour d'une fréquence $\omega_2$, avec : $\omega_2 = \omega_0 + \omega_1$.

La présente invention propose donc une architecture originale d'émetteur radiofréquence, combinant les architectures à conversion directe et à transposition de fréquence, et prévoyant en outre des moyens de traitement numérique, qui assurent un pré-traitement permettant d'atténuer, en sortie, la fréquence image introduite par les moyens de transposition en fréquence intermédiaire. Ainsi, cette nouvelle architecture combine le principal avantage de l'émetteur radiofréquence à conversion directe (pas de fréquence image) avec celui de l'émetteur radiofréquence à transposition de fréquence (pas de dégradation du signal utile), tout en évitant leurs inconvénients (sensibilité aux imperfections, filtre image performant).

Dans la suite de la description, on montre que la présente invention fonctionne parfaitement si les deux voies des moyens de conversion directe ont le même gain et si les sinus et cosinus délivrés par l'oscillateur compris dans les moyens de conversion directe ne souffrent pas d'une mauvaise mise en quadrature.

On montre également que, dans le cas contraire, un signal perturbateur de faible puissance apparaît à la fréquence image, mais le signal utile n'est pratiquement pas dégradé. Par conséquent, il n'est pas impératif d'utiliser, en sortie, un filtre atténuant la fréquence image du signal utile. En tout état de cause, lorsque les performances exigées de la chaîne d'émission nécessitent l'utilisation d'un tel filtre, ce dernier peut présenter des contraintes relâchées du fait que la fréquence image est très atténuée et peut donc être supprimée aisément. En d'autres termes, la qualité du signal émis peut être conservée sans impliquer des contraintes de filtrage image élevées. Dans certains cas, si ces contraintes sont suffisamment relâchées, le filtre image peut éventuellement être lui aussi intégré.

Il est à noter que la première transposition en fréquence et le traitement du signal sont effectués dans le domaine numérique, ce qui permet d'en exploiter la précision et le fort degré d'intégration (sur silicium par exemple).

On notera également que l'émetteur radiofréquence selon l'invention présente un très fort degré d'intégration (par exemple sur silicium), et peut même avantageusement être réalisé entièrement sous forme de circuit intégré. En effet, les moyens de conversion directe sont connus pour leur fort degré d'intégration silicium. Par ailleurs, le niveau d'intégration des moyens de transposition en fréquence intermédiaire peut être relativement élevé puisqu'il n'est pas nécessaire d'utiliser des filtres performants. Enfin, les moyens de traitement numérique peuvent se résumer à un ensemble d'éléments couramment utilisés dans les systèmes intégrés sur silicium, et notamment dans les émetteurs à transposition de fréquence. Cet ensemble d'éléments comprend par exemple un oscillateur contrôlé numériquement (ou NCO pour "Numerically Controlled Oscillator) et des opérateurs linéaires (multiplieurs et additionneurs).

Par ailleurs, le surplus de complexité comparée à une architecture à conversion directe est négligeable.

Enfin, le passage par une première fréquence intermédiaire $\omega_0$ générée dans le domaine numérique rend possible l'atténuation d'une éventuelle fuite de l'oscillateur local via les mélangeurs.

Dans un mode de réalisation avantageux de l'invention, ledit émetteur radiofréquence comprend en outre des moyens de compensation numérique des imperfections en gain et en phase desdits moyens de conversion directe.

Ainsi, en s'assurant qu'en sortie de l'émetteur radiofréquence le signal à la fréquence image est complètement atténué, on optimise les performances de l'émetteur radiofréquence selon l'invention et le signal résultant émis a des caractéristiques proches du cas idéal. Grâce à cette technique d'annulation d'image auto-calibrée, les erreurs introduites par la partie analogique (c'est-à-dire les moyens de conversion directe), sensible aux imperfections, sont compensées dans le domaine numérique.

Il est important de noter que, dans ce mode de réalisation particulier, aucun filtre de fréquence image n'est nécessaire. Cette nouvelle architecture d'émetteur radiofréquence fonctionne donc indépendamment de la fréquence porteuse choisie et est donc particulièrement adaptée aux systèmes de radiocommunication multistandards. Parmi les standards possibles, on peut citer, uniquement à titre d'exemple, les standards GSM (pour "Global System for Mobile communications" en anglais), DCS 1800 (pour "Digital Cellular System 1800 MHz" en anglais), PCS 1900 (pour "Personal Communication System" en anglais), DECT (pour "Digital European Cordless Telecommunications" en anglais), UMTS (pour "Universal Mobile Telecommunication System" en anglais), ...

Préférentiellement, lesdits moyens de conversion analogique/numérique présentent une fréquence de travail sensiblement identique à la fréquence de travail de moyens de conversion numérique/analogique compris dans lesdits moyens de conversion directe.

De façon préférentielle, lesdits moyens de compensation numérique sont inclus dans ledit circuit intégré. Ainsi, l'émetteur radiofréquence selon la présente invention peut être entièrement intégré, par exemple sur silicium.

D'autres caractéristiques et avantages de l'invention apparaîtront à la lecture de la description suivante de deux modes de réalisation préférentiels de l'invention, donnés à titre d'exemple indicatif et non limitatif, et des dessins annexés, dans lesquels :

- la figure 1 présente un schéma synoptique d'un premier mode de réalisation d'un émetteur radiofréquence selon la présente invention, avec annulation d'image "simple" ; et
- la figure 2 présente un schéma synoptique d'un second mode de réalisation d'un émetteur radiofréquence selon la présente invention, avec annulation d'image "auto-calibrée".

L'invention concerne donc un émetteur radiofréquence du type alimenté par deux signaux numériques en bande de base et en quadrature, i(nT) et q(nT), qui sont des images de deux flux binaires représentant une information à transmettre. T est la période d'échantillonnage.

De façon classique, et quelle que soit la modulation numérique mise en oeuvre, on cherche à obtenir un signal à émettre m(t) pouvant s'écrire :

$$m(t) = i(t).\cos(\omega t) - q(t).\sin(\omega t) \qquad (1)$$

avec $\omega$ (= $2\pi f$) la fréquence d'émission du signal (aussi appelée fréquence porteuse).

### 1. Premier mode de réalisation : annulation d'image "simple"

#### 1.1 Présentation de l'architecture

On présente maintenant, en relation avec la figure 1, un premier mode de réalisation d'un émetteur radiofréquence selon la présente invention.

Dans ce premier mode de réalisation, l'émetteur radiofréquence comprend des moyens 1 de transposition en fréquence intermédiaire et de traitement numérique et des moyens 2 de conversion directe.

Les moyens 1 de transposition en fréquence intermédiaire et de traitement numérique génèrent deux signaux $m_1(nT)$ et $m_2(nT)$ à une fréquence intermédiaire $\omega_0$ et en quadrature. Ils comprennent :

- un oscillateur numérique (NCO, non représenté) à une fréquence intermédiaire $\omega_0$, délivrant les signaux suivants : $\cos(\omega_0.nT)$ et $\sin(\omega_0.nT)$ ;
- quatre multiplieurs $3_1$ à $3_4$ ; et
- deux additionneurs $4_1$ et $4_2$.

Les multiplieurs $3_1$ à $3_4$ et les additionneurs $4_1$ et $4_2$ sont agencés de façon que les signaux $m_1(nT)$ et $m_2(nT)$ soient de la forme :

$$m_1(nT) = i(nT).\cos(\omega_0.nT) - q(nT).\sin(\omega_0.nT)$$

$$m_2(nT) = - i(nT).\sin(\omega_0.nT) - q(nT).\cos(\omega_0.nT)$$

Les moyens 2 de conversion directe génèrent un signal résultant m(t). Ils comprennent :

- sur chacune des deux voies en quadrature, un convertisseur numérique/analogique (CNA) $5_1$, $5_2$ et un filtre passe-bas $6_1$, $6_2$, permettant de transformer les deux signaux numériques $m_1(nT)$ et $m_2(nT)$ en deux signaux analogiques $m_1(t)$ et $m_2(t)$ ;
- un oscillateur local 7 à une fréquence d'émission $\omega_1$, délivrant les signaux suivants : $\cos(\omega_1.t)$ et $\sin(\omega_1.t)$ ;
- deux multiplieurs $8_1$ et $8_2$ ;
- un additionneur 9

Les multiplieurs $8_1$ et $8_2$ et l'additionneur 9 sont agencés de façon que le signal résultant m(t) soit de la forme :

$$m(t) = g_1.m_1(t).\cos(\omega_1 t+\theta_1) + g_2.m_2(t).\sin(\omega_1 t+\theta_2)$$

où $g_1$ et $g_2$ sont les gains respectifs des deux voies en quadrature des moyens 2 de conversion directe, et $\theta_1$ et $\theta_2$

sont les déphasages respectifs des deux voies en quadrature des moyens 2 de conversion directe.

Comme présenté en détail dans la suite de la description, on montre que le signal résultant se trouve au final modulé autour d'une fréquence $\omega_2$ (= $\omega_0 + \omega_1$).

Optionnellement, un filtre 17 à la fréquence image $\omega_{-2}$ (=$\omega_1 - \omega_0$) peut être placé en sortie de l'émetteur radiofréquence. Ce filtre 17 peut éventuellement être lui aussi inclus dans le circuit intégré sous la forme duquel est réalisé l'émetteur radiofréquence.

**1.2 Explication du cas idéal**

Le principe consiste donc à générer deux signaux $m_1(t)$ et $m_2(t)$ composés des deux voies en quadrature i(t) et q(t).

$$\begin{aligned} m_1(t) &= i(t).\cos(\omega_0 t) - q(t).\sin(\omega_0 t) \\ m_2(t) &= -i(t).\sin(\omega_0 t) - q(t).\cos(\omega_0 t) \end{aligned} \qquad (2)$$

où $\omega_0$ (= $2\pi.f_o$) est la première fréquence intermédiaire générée dans le domaine numérique.

Ensuite, les moyens 2 de conversion directe transposent les deux signaux autour de la fréquence porteuse $\omega_1$ en les multipliant par $\sin(\omega_1 t+\phi)$ et $\cos(\omega_1 t+\phi)$.

Le signal résultant m(t) s'écrit de la manière suivante :

$$\begin{aligned} m(t) &= m_1(t).\cos(\omega_1 t + \phi) + m_2(t).\sin(\omega_1 t + \phi) \\ &= i(t).\cos(\omega_0 t + \omega_1 t + \phi) - q(t).\sin(\omega_0 t + \omega_1 t + \phi) \end{aligned} \qquad (3)$$

$$m(t) = i(t).\cos(\omega_2 t + \phi) - q(t).\sin(\omega_2 t + \phi) \qquad (4)$$

On obtient dont un signal modulé autour de la porteuse $\omega_2 = \omega_0 + \omega_1$, dont la particularité est de ne pas avoir de fréquence image autour de $\omega_1$. Le résultat formulé dans l'équation (4) se vérifie dans le cas idéal où l'émetteur à conversion directe a des caractéristiques parfaites. Malheureusement, ceci est rarement le cas.

**1.3 Explication du cas réel**

En tenant compte des imperfections, le signal résulant émis m(t) s'écrit :

$$m(t) = g_1.\, m_1(t).\cos(\omega_1 t + \theta_1) + g_2.m_2(t).\sin(\omega_1 t + \theta_2) \qquad (5)$$

L'équation (2) permet d'écrire l'équation (5) en faisant apparaître i(t) et q(t) :

$$m(t) = i(t).\left[g_1.\cos\omega_0 t.\cos(\omega_1 t + \theta_1) - g_2.\sin\omega_0 t.\sin(\omega_1 t + \theta_2)\right] - q(t).\left[g_1.\sin\omega_0 t.\cos(\omega_1 t + \theta_1) + g_2.\cos\omega_0 t.\sin(\omega_1 t + \theta_2)\right]$$

$$m(t) = \frac{i(t)}{2}.\left\{\begin{array}{l} g_1\left[\cos(\omega_0 t - \omega_1 t - \theta_1) + \cos(\omega_0 t + \omega_1 t + \theta_1)\right] \\ - g_2\left[\cos(\omega_0 t - \omega_1 t - \theta_2) - \cos(\omega_0 t + \omega_1 t + \theta_2)\right] \end{array}\right\} - \frac{q(t)}{2}.\left\{\begin{array}{l} g_1\left[\sin(\omega_0 t - \omega_1 t - \theta_1) + \sin(\omega_0 t + \omega_1 t + \theta_1)\right] \\ - g_2\left[\sin(\omega_0 t - \omega_1 t - \theta_2) - \sin(\omega_0 t + \omega_1 t + \theta_2)\right] \end{array}\right\} \quad (6)$$

$$m(t) = \frac{i(t)}{2}.\left\{\begin{array}{l} g_1.\cos(\omega_0 t - \omega_1 t - \theta_1) - g_2.\cos(\omega_0 t - \omega_1 t - \theta_2) \\ + g_1.\cos(\omega_0 t + \omega_1 t + \theta_1) + g_2.\cos(\omega_0 t + \omega_1 t + \theta_2) \end{array}\right\} - \frac{q(t)}{2}.\left\{\begin{array}{l} g_1.\sin(\omega_0 t - \omega_1 t - \theta_1) - g_2.\sin(\omega_0 t - \omega_1 t - \theta_2) \\ + g_1.\sin(\omega_0 t + \omega_1 t + \theta_1) + g_2.\sin(\omega_0 t + \omega_1 t + \theta_2) \end{array}\right\}$$

En vue de simplifier le résultat décrit par l'équation (6), on pose :

$$\left.\begin{array}{l} \theta_1 = \theta - \frac{\Delta\theta}{2} \\ \theta_2 = \theta + \frac{\Delta\theta}{2} \end{array}\right\} \text{ avec } \theta = \frac{\theta_1 + \theta_2}{2} \quad \text{et} \quad \left.\begin{array}{l} g_1 = g - \frac{\Delta g}{2} \\ g_2 = g + \frac{\Delta g}{2} \end{array}\right\} \text{ avec } g = \frac{g_1 + g_2}{2} \quad (7)$$

Ce qui nous permet d'exprimer m(t) sous la forme :

$$m(t)=\frac{i(t)}{2}.\left\{\begin{array}{l} g.\left[\cos\left(\omega_0 t-\omega_1 t-\theta+\frac{\Delta\theta}{2}\right)-\cos\left(\omega_0 t-\omega_1 t-\theta-\frac{\Delta\theta}{2}\right)\right] \\ -\frac{\Delta g}{2}.\left[\cos\left(\omega_0 t-\omega_1 t-\theta+\frac{\Delta\theta}{2}\right)+\cos\left(\omega_0 t-\omega_1 t-\theta-\frac{\Delta\theta}{2}\right)\right] \\ +g.\left[\cos\left(\omega_0 t+\omega_1 t+\theta-\frac{\Delta\theta}{2}\right)+\cos\left(\omega_0 t+\omega_1 t+\theta+\frac{\Delta\theta}{2}\right)\right] \\ -\frac{\Delta g}{2}.\left[\cos\left(\omega_0 t+\omega_1 t+\theta-\frac{\Delta\theta}{2}\right)-\cos\left(\omega_0 t+\omega_1 t+\theta+\frac{\Delta\theta}{2}\right)\right] \end{array}\right\}$$

$$-\frac{q(t)}{2}.\left\{\begin{array}{l} g.\left[\sin\left(\omega_0 t-\omega_1 t-\theta+\frac{\Delta\theta}{2}\right)-\sin\left(\omega_0 t-\omega_1 t-\theta-\frac{\Delta\theta}{2}\right)\right] \\ -\frac{\Delta g}{2}.\left[\sin\left(\omega_0 t-\omega_1 t-\theta+\frac{\Delta\theta}{2}\right)+\sin\left(\omega_0 t-\omega_1 t-\theta-\frac{\Delta\theta}{2}\right)\right] \\ +g.\left[\sin\left(\omega_0 t+\omega_1 t+\theta-\frac{\Delta\theta}{2}\right)+\sin\left(\omega_0 t+\omega_1 t+\theta+\frac{\Delta\theta}{2}\right)\right] \\ -\frac{\Delta g}{2}.\left[\sin\left(\omega_0 t+\omega_1 t+\theta-\frac{\Delta\theta}{2}\right)-\sin\left(\omega_0 t+\omega_1 t+\theta+\frac{\Delta\theta}{2}\right)\right] \end{array}\right\} \quad (8)$$

$$m(t)=i(t).\left\{\begin{array}{l} -g.\sin(\omega_0 t-\omega_1 t-\theta)\sin\left(\frac{\Delta\theta}{2}\right)-\frac{\Delta g}{2}.\cos(\omega_0 t-\omega_1 t-\theta)\cos\left(\frac{\Delta\theta}{2}\right) \\ +g.\cos(\omega_0 t+\omega_1 t+\theta)\cos\left(\frac{\Delta\theta}{2}\right)-\frac{\Delta g}{2}.\sin(\omega_0 t+\omega_1 t+\theta)\sin\left(\frac{\Delta\theta}{2}\right) \end{array}\right\}$$

$$-q(t).\left\{\begin{array}{l} g.\cos(\omega_0 t-\omega_1 t-\theta)\sin\left(\frac{\Delta\theta}{2}\right)-\frac{\Delta g}{2}.\sin(\omega_0 t-\omega_1 t-\theta)\cos\left(\frac{\Delta\theta}{2}\right) \\ +g.\sin(\omega_0 t+\omega_1 t+\theta)\cos\left(\frac{\Delta\theta}{2}\right)+\frac{\Delta g}{2}.\cos(\omega_0 t+\omega_1 t+\theta)\sin\left(\frac{\Delta\theta}{2}\right) \end{array}\right\} \quad (9)$$

En faisant intervenir la fréquence porteuse $\omega_2 = \omega_1 + \omega_0$ et sa fréquence image $\omega_{-2} = \omega_1 - \omega_0$ :

$$m(t)=i(t).\left\{\begin{array}{l} g.\sin(\omega_{-2} t+\theta)\sin\left(\frac{\Delta\theta}{2}\right)-\frac{\Delta g}{2}.\cos(\omega_{-2} t+\theta)\cos\left(\frac{\Delta\theta}{2}\right) \\ +g.\cos(\omega_2 t+\theta)\cos\left(\frac{\Delta\theta}{2}\right)-\frac{\Delta g}{2}.\sin(\omega_2 t+\theta)\sin\left(\frac{\Delta\theta}{2}\right) \end{array}\right\}$$

$$-q(t).\left\{\begin{array}{l} g.\cos(\omega_{-2} t+\theta)\sin\left(\frac{\Delta\theta}{2}\right)+\frac{\Delta g}{2}.\sin(\omega_{-2} t+\theta)\cos\left(\frac{\Delta\theta}{2}\right) \\ +g.\sin(\omega_2 t+\theta)\cos\left(\frac{\Delta\theta}{2}\right)+\frac{\Delta g}{2}.\cos(\omega_2 t+\theta)\sin\left(\frac{\Delta\theta}{2}\right) \end{array}\right\} \quad (10)$$

$$\begin{aligned} m(t) = {} & g.\cos\left(\frac{\Delta\theta}{2}\right).\left[i(t).\cos(\omega_2 t+\theta) - q(t).\sin(\omega_2 t+\theta)\right] \\ & - \frac{\Delta g}{2}.\sin\left(\frac{\Delta\theta}{2}\right).\left[i(t).\sin(\omega_2 t+\theta) + q(t).\cos(\omega_2 t+\theta)\right] \\ & + g.\sin\left(\frac{\Delta\theta}{2}\right).\left[i(t).\sin(\omega_{-2} t+\theta) - q(t).\cos(\omega_{-2} t+\theta)\right] \\ & - \frac{\Delta g}{2}.\cos\left(\frac{\Delta\theta}{2}\right).\left[i(t).\cos(\omega_{-2} t+\theta) + q(t).\sin(\omega_{-2} t+\theta)\right] \end{aligned} \quad (11)$$

Le signal résultant m(t) est donc constitué de :

- un signal utile (modulé autour de la porteuse $\omega_2$), pondéré d'un gain égal à

$$g.\cos\left(\frac{\Delta\theta}{2}\right);$$

- une composante indésirable, dont l'amplitude est de l'ordre de

$$\frac{\Delta g}{2}.\sin\left(\frac{\Delta\theta}{2}\right);$$

- une image en $\omega_{-2}$ (due aux imperfections), dont la puissance dépend de l'écart en gain $\Delta g$ et en phase $\Delta\theta$ entre les deux voies.

Le résultat de l'équation (11) montre que les imperfections en gain et en phase génèrent une composante parasite en $\omega_{-2}$ de puissance suffisamment faible pour être facilement filtrée. Par contre, elles influent très peu sur la qualité du signal utile.

Si on choisit une erreur sur le gain $\Delta g$ = 3% et sur la phase (quadrature) $\Delta\theta$ = 3°, le C/I du signal utile (puissance du signal / puissance du perturbateur à la fréquence $\omega_2$) est de 68 dBc, au lieu de 28 dBc pour une architecture à conversion directe classique. Le niveau de puissance du perturbateur présent à la fréquence image $\omega_{-2}$ est environ 28 dB en dessous du signal utile alors qu'il serait 25 fois plus élevé avec une structure à transposition de fréquence classique.

Comparée aux autres architectures, ce système original présente les avantages suivants :

- un gain identique pour les voies i(t) et q(t) ;
- une dégradation négligeable du signal utile ($\approx\Delta g.\Delta\theta/4$) ;
- une fréquence image très atténuée et pouvant être supprimée avec un filtre aux contraintes relâchées ;
- une complexité réduite comparée à un émetteur à conversion directe grâce à un traitement du signal effectué dans le domaine numérique.

De plus, le passage par une première fréquence intermédiaire FI ($\omega_0$) générée dans le domaine numérique permet de pouvoir atténuer l'éventuelle fuite de l'oscillateur local via les mélangeurs.

**2. Second mode de réalisation : annulation d'image "auto-calibrée"**

**2.1 Présentation de l'architecture**

On présente maintenant, en relation avec la figure 2, un second mode de réalisation d'un émetteur radiofréquence selon la présente invention.

En effet, afin d'aller encore plus loin avec l'émetteur radiofréquence selon la présente invention, on se propose

de compenser numériquement les erreurs en gain et en phase introduites dans les moyens 2 de conversion directe. Ainsi, en sortie, le signal présent à la fréquence image sera complètement atténué. Ce second mode de réalisation diffère du premier mode de réalisation (présenté ci-dessus en relation avec la figure 1), en ce qu'il comprend en outre des moyens 10, 11 de compensation numérique des imperfections en gain $\Delta g$ et en phase $\Delta\theta$ des moyens 2 de conversion directe. Ces moyens de compensation comprennent eux-mêmes des moyens 10 d'estimation des imperfections $\Delta g$ et $\Delta\theta$, et des moyens 11 d'application d'une correction aux deux signaux $m_1(t)$ et $m_2(t)$, de façon à générer deux signaux corrigés, $m_{1c}(t)$ et $m_{2c}(t)$.

Dans le mode de réalisation présenté sur la figure 2, les moyens 10 d'estimation des imperfections comprennent :

- des moyens 12 de transposition, assurant une troisième transposition en fréquence effectuée dans le domaine analogique, par multiplication du signal résultant m(t) par la fréquence d'émission $\omega_1$, de façon à générer un signal intermédiaire : $m'(t) = g_3.m(t).\cos(\omega_1 t+\theta_1)$, où $g_3$ est le gain introduit par les moyens 12 de transposition, 13 de filtrage, 14 de conversion analogique/numérique.
- un filtre passe-bas 13, assurant un filtrage du signal intermédiaire m'(t) et générant un signal intermédiaire filtré m'(t) ;
- un convertisseur analogique/numérique (CAN) 14, permettant de convertir en numérique le signal intermédiaire filtré m'(t) ;
- des moyens 15 de calcul des imperfections en gain $\Delta g$ et en phase $\Delta\theta$ à partir du signal intermédiaire filtré numérique m'(t).

Il est à noter que les moyens 1 de transposition en fréquence intermédiaire et de traitement numérique, les moyens 15 de calcul des imperfections et les moyens 11 d'application d'une correction aux deux signaux $m_1(t)$ et $m_2(t)$ peuvent être compris dans un même processeur de signaux numériques (ou DSP) 16. Le fonctionnement de ce second mode de réalisation de l'émetteur radiofréquence peut être décomposé en trois phases successives, à savoir :

- récupération du signal résultant émis m(t) ;
- calcul des coefficients de correction $\Delta g$ et $\Delta\theta$ ;
- calcul du signal résultant corrigé $m_c(t)$.

Ces trois phases sont maintenante décrites successivement, dans les paragraphes 2.2 à 2.4 respectivement.

**2.2 Récupération du signal résultant émis**

Le signal résultant m(t) est multiplié par la fréquence $\omega_1$ de l'oscillateur local 7 (ce dernier est compris dans les moyens 2 de conversion directe). Ainsi, m(t) est transposé à une fréquence plus basse, fixe, avant conversion analogique/numérique.

Le signal résultant s'écrit :

$$m_3'(t) = g_3.m(t).\cos\left(\omega_1 t + \theta - \frac{\Delta\theta}{2}\right).$$

En développant le produit ci-dessus et en supposant $g_3 = 1$, m'(t) s'exprime :

$$m_3'(t) = g.\cos\left(\frac{\Delta\theta}{2}\right).\left\{\begin{array}{l}\frac{i(t)}{2}.\left[\cos\left(\omega_0 t + \frac{\Delta\theta}{2}\right) + \cos\left(2\omega_1 t + \omega_0 t + 2\theta - \frac{\Delta\theta}{2}\right)\right] \\ -\frac{q(t)}{2}.\left[\sin\left(\omega_0 t + \frac{\Delta\theta}{2}\right) + \sin\left(2\omega_1 t + \omega_0 t + 2\theta - \frac{\Delta\theta}{2}\right)\right]\end{array}\right\}$$

$$-\frac{\Delta g}{2}.\sin\left(\frac{\Delta\theta}{2}\right).\left\{\begin{array}{l}\frac{i(t)}{2}.\left[\sin\left(\omega_0 t + \frac{\Delta\theta}{2}\right) + \sin\left(2\omega_1 t + \omega_0 t + 2\theta - \frac{\Delta\theta}{2}\right)\right] \\ +\frac{q(t)}{2}.\left[\cos\left(\omega_0 t + \frac{\Delta\theta}{2}\right) + \cos\left(2\omega_1 t + \omega_0 t + 2\theta - \frac{\Delta\theta}{2}\right)\right]\end{array}\right\}$$

$$+g.\sin\left(\frac{\Delta\theta}{2}\right).\left\{\begin{array}{l}\frac{i(t)}{2}.\left[\sin\left(-\omega_0 t + \frac{\Delta\theta}{2}\right) + \sin\left(2\omega_1 t - \omega_0 t + 2\theta - \frac{\Delta\theta}{2}\right)\right] \\ -\frac{q(t)}{2}.\left[\cos\left(-\omega_0 t + \frac{\Delta\theta}{2}\right) + \cos\left(2\omega_1 t - \omega_0 t + 2\theta - \frac{\Delta\theta}{2}\right)\right]\end{array}\right\}$$

$$-\frac{\Delta g}{2}.\cos\left(\frac{\Delta\theta}{2}\right).\left\{\begin{array}{l}\frac{i(t)}{2}.\left[\cos\left(-\omega_0 t + \frac{\Delta\theta}{2}\right) + \cos\left(2\omega_1 t - \omega_0 t + 2\theta - \frac{\Delta\theta}{2}\right)\right] \\ +\frac{q(t)}{2}.\left[\sin\left(-\omega_0 t + \frac{\Delta\theta}{2}\right) + \sin\left(2\omega_1 t - \omega_0 t + 2\theta - \frac{\Delta\theta}{2}\right)\right]\end{array}\right\}$$

(12)

Le filtrage passe-bas (filtre 13) supprime les composantes $2\omega_1 t \pm \omega_0 t$ et donne :

$$\begin{aligned} m'(t) = {} & g.\cos\left(\frac{\Delta\theta}{2}\right).\left[\frac{i(t)}{2}.\cos\left(\omega_0 t + \frac{\Delta\theta}{2}\right) - \frac{q(t)}{2}.\sin\left(\omega_0 t + \frac{\Delta\theta}{2}\right)\right] \\ & -\frac{\Delta g}{2}.\sin\left(\frac{\Delta\theta}{2}\right).\left[\frac{i(t)}{2}.\sin\left(\omega_0 t + \frac{\Delta\theta}{2}\right) + \frac{q(t)}{2}.\cos\left(\omega_0 t + \frac{\Delta\theta}{2}\right)\right] \\ & -g.\sin\left(\frac{\Delta\theta}{2}\right).\left[\frac{i(t)}{2}.\sin\left(\omega_0 t - \frac{\Delta\theta}{2}\right) + \frac{q(t)}{2}.\cos\left(\omega_0 t - \frac{\Delta\theta}{2}\right)\right] \\ & -\frac{\Delta g}{2}.\cos\left(\frac{\Delta\theta}{2}\right).\left[\frac{i(t)}{2}.\cos\left(\omega_0 t - \frac{\Delta\theta}{2}\right) - \frac{q(t)}{2}.\sin\left(\omega_0 t - \frac{\Delta\theta}{2}\right)\right] \end{aligned} \qquad (13)$$

$$m'(t) = g.\cos\left(\frac{\Delta\theta}{2}\right).\begin{Bmatrix} \frac{i(t)}{2}.\left[\cos(\omega_0 t)\cos\left(\frac{\Delta\theta}{2}\right) - \sin(\omega_0 t)\sin\left(\frac{\Delta\theta}{2}\right)\right] \\ -\frac{q(t)}{2}.\left[\sin(\omega_0 t)\cos\left(\frac{\Delta\theta}{2}\right) + \cos(\omega_0 t)\sin\left(\frac{\Delta\theta}{2}\right)\right] \end{Bmatrix}$$

$$-\frac{\Delta g}{2}.\sin\left(\frac{\Delta\theta}{2}\right).\begin{Bmatrix} \frac{i(t)}{2}.\left[\sin(\omega_0 t)\cos\left(\frac{\Delta\theta}{2}\right) + \cos(\omega_0 t)\sin\left(\frac{\Delta\theta}{2}\right)\right] \\ +\frac{q(t)}{2}.\left[\cos(\omega_0 t)\cos\left(\frac{\Delta\theta}{2}\right) - \sin(\omega_0 t)\sin\left(\frac{\Delta\theta}{2}\right)\right] \end{Bmatrix}$$

$$-g.\sin\left(\frac{\Delta\theta}{2}\right).\begin{Bmatrix} \frac{i(t)}{2}.\left[\sin(\omega_0 t)\cos\left(\frac{\Delta\theta}{2}\right) - \cos(\omega_0 t)\sin\left(\frac{\Delta\theta}{2}\right)\right] \\ +\frac{q(t)}{2}.\left[\cos(\omega_0 t)\cos\left(\frac{\Delta\theta}{2}\right) + \sin(\omega_0 t)\sin\left(\frac{\Delta\theta}{2}\right)\right] \end{Bmatrix}$$

$$-\frac{\Delta g}{2}.\cos\left(\frac{\Delta\theta}{2}\right).\begin{Bmatrix} \frac{i(t)}{2}.\left[\cos(\omega_0 t)\cos\left(\frac{\Delta\theta}{2}\right) + \sin(\omega_0 t)\sin\left(\frac{\Delta\theta}{2}\right)\right] \\ -\frac{q(t)}{2}.\left[\sin(\omega_0 t)\cos\left(\frac{\Delta\theta}{2}\right) - \cos(\omega_0 t)\sin\left(\frac{\Delta\theta}{2}\right)\right] \end{Bmatrix} \qquad (14)$$

$$m'(t) = g.\begin{Bmatrix} \frac{i(t)}{2}.\left[\cos(\omega_0 t)\cos^2\left(\frac{\Delta\theta}{2}\right) - \sin(\omega_0 t)\frac{\sin(\Delta\theta)}{2}\right] \\ -\frac{q(t)}{2}.\left[\sin(\omega_0 t)\cos^2\left(\frac{\Delta\theta}{2}\right) + \cos(\omega_0 t)\frac{\sin(\Delta\theta)}{2}\right] \end{Bmatrix}$$

$$-\frac{\Delta g}{2}.\begin{Bmatrix} \frac{i(t)}{2}.\left[\sin(\omega_0 t)\frac{\sin(\Delta\theta)}{2} + \cos(\omega_0 t)\sin^2\left(\frac{\Delta\theta}{2}\right)\right] \\ +\frac{q(t)}{2}.\left[\cos(\omega_0 t)\frac{\sin(\Delta\theta)}{2} - \sin(\omega_0 t)\sin^2\left(\frac{\Delta\theta}{2}\right)\right] \end{Bmatrix}$$

$$-g.\begin{Bmatrix} \frac{i(t)}{2}.\left[\sin(\omega_0 t)\frac{\sin(\Delta\theta)}{2} - \cos(\omega_0 t)\sin^2\left(\frac{\Delta\theta}{2}\right)\right] \\ +\frac{q(t)}{2}.\left[\cos(\omega_0 t)\frac{\sin(\Delta\theta)}{2} + \sin(\omega_0 t)\sin^2\left(\frac{\Delta\theta}{2}\right)\right] \end{Bmatrix}$$

$$-\frac{\Delta g}{2}.\begin{Bmatrix} \frac{i(t)}{2}.\left[\cos(\omega_0 t)\cos^2\left(\frac{\Delta\theta}{2}\right) + \sin(\omega_0 t)\frac{\sin(\Delta\theta)}{2}\right] \\ -\frac{q(t)}{2}.\left[\sin(\omega_0 t)\cos^2\left(\frac{\Delta\theta}{2}\right) - \cos(\omega_0 t)\frac{\sin(\Delta\theta)}{2}\right] \end{Bmatrix} \qquad (15)$$

$$m'(t) = g.\left\{\frac{i(t)}{2}.\left[\cos(\omega_0 t) - \sin(\omega_0 t)\sin(\Delta\theta)\right] - \frac{q(t)}{2}\left[\sin(\omega_0 t) + \cos(\omega_0 t)\sin(\Delta\theta)\right]\right\} - \frac{\Delta g}{2}.\left\{\frac{i(t)}{2}.\left[\cos(\omega_0 t) + \sin(\omega_0 t)\sin(\Delta\theta)\right] - \frac{q(t)}{2}\left[\sin(\omega_0 t) - \cos(\omega_0 t)\sin(\Delta\theta)\right]\right\} \quad (16)$$

$$m'(t) = \left\{\frac{i(t)}{2}.\left[g - \frac{\Delta g}{2}\right] - \frac{q(t)}{2}.\left[g + \frac{\Delta g}{2}\right]\sin(\Delta\theta)\right\}\cos(\omega_0 t) - \left\{\frac{i(t)}{2}.\left[g + \frac{\Delta g}{2}\right]\sin(\Delta\theta) + \frac{q(t)}{2}.\left[g - \frac{\Delta g}{2}\right]\right\}\sin(\omega_0 t) \quad (17)$$

$$m'(t) = i'(t).\cos(\omega_0 t) - q'(t).\sin(\omega_0 t) \quad \text{avec} \quad \begin{cases} i'(t) = a.i(t) - b.q(t) \\ q'(t) = b.i(t) + a.q(t) \end{cases} \quad a = \frac{2g - \Delta g}{4}, \quad b = \frac{2g + \Delta g}{4}\sin(\Delta\theta) \quad (18)$$

A partir de l'équation (18), on cherche à extraire les coefficients 'a' et 'b' afin d'en déduire les valeurs de $\Delta g$ et $\Delta\theta$. Sachant que $i^2(t) + q^2(t) = 1$, on a :

$$\begin{aligned} a &= i(t).i'(t) + q(t).q'(t) \\ b &= i(t).q'(t) - q(t).i'(t) \end{aligned} \quad (19)$$

Dans le cas réel où $g_3 \neq 0$, les coefficients 'a' et 'b' s'écrivent :

$$a = g_3.\frac{2g-\Delta g}{4} \text{ et } b = g_3.\frac{2g+\Delta g}{4}\sin\Delta\theta \quad (20)$$

**2.3 Calcul des coefficients de correction**

Connaissant les valeurs théoriques des gains 'g' et '$g_3$', on veut calculer $\Delta g$, $\Delta\theta$ et la valeur réelle de $g_3$ à partir des coefficients 'a' et 'b'. L'équation (20) nous donne :

$$a+b=\frac{g_3}{4}[2g(1+\sin\Delta\theta)-\Delta g(1-\sin\Delta\theta)] \quad (21)$$

En supposant, dans une première approximation $\sin\Delta\theta \approx 0$ et $\Delta g << g$, on en déduit une estimation du gain $g_3$ :

$$\hat{g}_3 = \frac{2.(a+b)}{g} = \frac{2}{g}[i'(t) + q'(t)][i(t) - q(t)] \quad (22)$$

En conservant l'approximation $\sin\Delta\theta \approx 0$ et connaissant la valeur théorique de $g_3$, on détermine rapidement $\Delta g$ :

$$\Delta g \approx \frac{2g}{g_3}\cdot(g_3 - \hat{g}_3) = 2g - \frac{4}{g_3}[i'(t) + q'(t)][i(t) - q(t)] \quad (23)$$

En faisant intervenir le gain calculé dans (22), le coefficient $\Delta\theta$ se déduit de l'équation (20) avec l'hypothèse que sin $\Delta\theta \approx \Delta\theta$ et $\Delta g.\sin \Delta\theta \approx 0$ :

$$\Delta\theta \approx \frac{b}{g.g_3} = \frac{1}{g.g_3}[i(t).q'(t) - q(t).\,i'(t)] \quad (24)$$

En choisissant des valeurs en puissance de 2 pour les gains théoriques 'g' et 'g3', on simplifie le calcul des coefficients de correction en évitant une division coûteuse en silicium.

**2.4 Calcul du signal résultant corrigé**

Après calcul des coefficients de correction $\Delta g$ et $\Delta\theta$, il faut construire le nouveau signal d'émission corrigé $m_c$ (t) :

$$m_c(t) = m_{1c}(t).\left(g - \frac{\Delta g}{2}\right)\cos\left(\omega_1 t + \theta - \frac{\Delta\theta}{2}\right) + m_{2c}(t).\left(g + \frac{\Delta g}{2}\right)\sin\left(\omega_1 t + \theta + \frac{\Delta\theta}{2}\right) \quad (25)$$

où $m_{1c}(t)$ et $m_{2c}(t)$ sont les deux voies corrigées en gain et en phase :

$$\begin{aligned} m_{1c}(t) &= \frac{1}{\left(1 - \frac{\Delta g}{2g}\right)}\left[i(t).\cos\left(\omega_0 t - \frac{\Delta\theta}{2}\right) - q(t).\sin\left(\omega_0 t - \frac{\Delta\theta}{2}\right)\right] \\ m_{2c}(t) &= \frac{-1}{\left(1 + \frac{\Delta g}{2g}\right)}\left[i(t).\sin\left(\omega_0 t + \frac{\Delta\theta}{2}\right) + q(t).\cos\left(\omega_0 t + \frac{\Delta\theta}{2}\right)\right] \end{aligned} \quad (26)$$

En développant l'équation (25), il vient :

$$\begin{aligned} m_c(t) = {} & i(t).\cos\left(\omega_1 t + \theta - \frac{\Delta\theta}{2}\right).\cos\left(\omega_0 t - \frac{\Delta\theta}{2}\right) - q(t).\cos\left(\omega_1 t + \theta - \frac{\Delta\theta}{2}\right).\sin\left(\omega_0 t - \frac{\Delta\theta}{2}\right) \\ & - i(t).\sin\left(\omega_1 t + \theta + \frac{\Delta\theta}{2}\right).\sin\left(\omega_0 t + \frac{\Delta\theta}{2}\right) - q(t).\sin\left(\omega_1 t + \theta + \frac{\Delta\theta}{2}\right).\cos\left(\omega_0 t + \frac{\Delta\theta}{2}\right) \end{aligned} \quad (27)$$

$$\begin{aligned} m_c(t) = {} & \frac{i(t)}{2}.\left[\cos(\omega_1 t - \omega_0 t + \theta) + \cos(\omega_1 t + \omega_0 t + \theta - \Delta\theta)\right] \\ & + \frac{q(t)}{2}.\left[\sin(\omega_1 t - \omega_0 t + \theta) - \sin(\omega_1 t + \omega_0 t + \theta - \Delta\theta)\right] \\ & - \frac{i(t)}{2}.\left[\cos(\omega_1 t - \omega_0 t + \theta) - \cos(\omega_1 t + \omega_0 t + \theta + \Delta\theta)\right] \\ & - \frac{q(t)}{2}.\left[\sin(\omega_1 t - \omega_0 t + \theta) + \sin(\omega_1 t + \omega_0 t + \theta + \Delta\theta)\right] \end{aligned} \quad (28)$$

$$m_c(t) = \frac{i(t)}{2}.\left[\cos(\omega_1 t + \omega_0 t + \theta - \Delta\theta) + \cos(\omega_1 t + \omega_0 t + \theta + \Delta\theta)\right] - \frac{q(t)}{2}.\left[\sin(\omega_1 t + \omega_0 t + \theta - \Delta\theta) + \sin(\omega_1 t + \omega_0 t + \theta + \Delta\theta)\right] \quad (29)$$

$$m_c(t) = [i(t).\cos(\omega_1 t + \omega_0 t + \theta) - q(t).\sin(\omega_1 t + \omega_0 t + \theta)]\cos\Delta\theta \quad (30)$$

En posant à nouveau $\omega_2 = \omega_1 + \omega_0$, on retrouve l'expression du signal m(t) formulée dans le cas idéal (équation (4), avec g = 1) avec un gain cos $\Delta\theta$. En considérant $\cos\Delta\theta \approx 1 - \frac{\Delta\theta^2}{2} \approx 1$, on simplifie le système de correction sans dégrader la qualité signal puisque ce gain s'applique aux deux voies i(t) et q(t). Si $\Delta\theta$ = 5°, l'erreur résultante est d'environ 0,4% sur l'amplitude du signal émis.

L'expression simplifiée des deux voies corrigées en gain et en phase $m_{1c}(t)$ et $m_{2c}(t)$ s'écrit :

$$m_{1c}(t) = \left(1 + \frac{\Delta g}{2g}\right).\left[i(t).\cos\left(\omega_0 t - \frac{\Delta\theta}{2}\right) - q(t).\sin\left(\omega_0 t - \frac{\Delta\theta}{2}\right)\right]$$
$$m_{2c}(t) = -\left(1 - \frac{\Delta g}{2g}\right).\left[i(t).\sin\left(\omega_0 t + \frac{\Delta\theta}{2}\right) + q(t).\cos\left(\omega_0 t + \frac{\Delta\theta}{2}\right)\right] \quad (31)$$

En d'autres termes, les moyens 11 d'application d'une correction aux deux signaux $m_1(t)$ et $m_2(t)$ appliquent :

- sur la première voie : un gain égal à (1 + $\Delta$g/2g), ainsi qu'un déphasage égal à (- $\Delta\theta$/2) ;
- sur la seconde voie : un gain égal à (1 - $\Delta$g/2g), ainsi qu'un déphasage égal à (+ $\Delta\theta$/2).

De cette manière, on évite toute opération de division pour le calcul du signal corrigé ; dans l'hypothèse où la valeur théorique du gain 'g' est choisie de façon à être un multiple d'une puissance de 2.

Les algorithmes de calcul de $\Delta$g et $\Delta\theta$ ont été simulés avec succès : l'erreur est compensée après 5 itérations au plus, selon les ordres de grandeur de $\Delta$g et $\Delta\theta$ (jusqu'à 10 % et 8° respectivement) et avec une erreur allant jusqu'à 12% sur la valeur de $g_3$.

A travers la description détaillée ci-dessus de deux modes de réalisation particuliers, la nouvelle architecture d'émetteur radiofréquence selon la présente invention a été décrite.

On rappelle qu'elle combine les avantages de l'émetteur à conversion directe (pas de fréquence image) sans en avoir les inconvénients (pas de dégradation du signal utile). Grâce au système d'auto-calibrage, les erreurs introduites par la partie analogique sensible aux imperfections sont compensées dans le domaine numérique. Ainsi, le signal résultant qui est émis a des caractéristiques proches du cas idéal.

Les fonctions de traitement du signal sont réalisées dans le domaine numérique afin d'en exploiter la précision et le fort degré d'intégration sur silicium. Le convertisseur analogique/numérique (CAN) 14 est par exemple de type « delta-sigma passe-bande », dont la fréquence de travail est de préférence identique à celle des deux CNA $5_1$ et $5_2$. Le filtre analogique passe-bas 13 a des contraintes relâchées : un filtre d'ordre 2 est suffisant dans la plupart des cas.

L'émetteur radiofréquence selon l'invention présente une complexité relativement faible comparée au reste de la chaîne d'émission et possède l'avantage d'être complètement intégrable sur silicium.

## Revendications

1. Emetteur radiofréquence, du type alimenté par deux signaux numériques en bande de base et en quadrature (i (nT), q(nT)) qui sont des images de deux flux binaires représentant une information à transmettre, **caractérisé en ce qu'**il comprend :

   - des moyens (1) de transposition en fréquence intermédiaire et de traitement numérique, assurant une première transposition en fréquence effectuée dans le domaine numérique, à une fréquence intermédiaire $\omega_0$, desdits

signaux en bande de base, et générant, par combinaison, deux signaux à la fréquence intermédiaire et en quadrature ;

- des moyens (2) de conversion directe, assurant une seconde transposition en fréquence effectuée dans le domaine analogique, par multiplication ($8_1$, $8_2$) par une fréquence $\omega_1$, suivi d'une sommation (9), desdits deux signaux à la fréquence intermédiaire et en quadrature, de façon à générer un signal résultant (m/t)) qui se trouve au final modulé autour d'une fréquence $\omega_2$, avec : $\omega_2 = \omega_0 + \omega_1$.

**2.** Emetteur radiofréquence selon la revendication 1, **caractérisé en ce que** lesdits deux signaux à la fréquence intermédiaire et en quadrature sont de la forme :

* $m_1(t) = i(t).\cos(\omega_0 t) - q(t).\sin(\omega_0 t)$
* $m_2(t) = - i(t).\sin(\omega_0 t) - q(t).\cos(\omega_0 t)$

et **en ce que** ledit signal résultant est de la forme :

* $m(t) = g_1.m_1(t).\cos(\omega_1 t+\theta_1) + g_2.m_2(t).\sin(\omega_1 t+\theta_2)$

où :

- $g_1$ et $g_2$ sont les gains respectifs des deux voies en quadrature desdits moyens de conversion directe ;
- $\theta_1$ et $\theta_2$ sont les déphasages respectifs des deux voies en quadrature desdits moyens de conversion directe.

**3.** Emetteur radiofréquence selon l'une quelconque des revendications 1 et 2, **caractérisé en ce qu'**il est réalisé sous forme de circuit intégré.

**4.** Emetteur radiofréquence selon l'une quelconque des revendications 1 à 3, **caractérisé en ce qu'**il comprend en outre des moyens (17) de filtrage, recevant et filtrant ledit signal résultant, de façon à supprimer au moins en partie une composante parasite dudit signal résultant, à une fréquence $\omega_{-2}$ image de ladite fréquence $\omega_2$.

**5.** Emetteur radiofréquence selon les revendications 3 et 4, **caractérisé en ce qu'**au moins une partie desdits moyens (17) de filtrage est incluse dans ledit circuit intégré.

**6.** Emetteur radiofréquence selon l'une quelconque des revendications 1 à 5, **caractérisé en ce qu'**il comprend en outre des moyens (10, 11) de compensation numérique des imperfections en gain et en phase desdits moyens de conversion directe.

**7.** Emetteur radiofréquence selon la revendication 6, **caractérisé en ce que** lesdits moyens de compensation numérique comprennent :

- des moyens (10) d'estimation des imperfections en gain $\Delta g$ et en phase $\Delta\theta$ desdits moyens de conversion directe, avec :

  * $\Delta g = g_2 - g_1$
  * $\Delta\theta = \theta_2 - \theta_1$

- des moyens (11) d'application d'une correction auxdits deux signaux à la fréquence intermédiaire et en quadrature, de façon à générer deux signaux corrigés, $m_{1c}(t)$ et $m_{2c}(t)$, à la fréquence intermédiaire et en quadrature, le signal résultant corrigé correspondant s'écrivant :

  * $m_c(t) = g_1.m_{1c}(t).\cos(\omega_1 t+\theta_1) + g_2.m_{2c}(t).\sin(\omega_1 t+\theta_2)$

**8.** Emetteur radiofréquence selon la revendication 7, **caractérisé en ce que** lesdits moyens (10) d'estimation des imperfections comprennent :

- des moyens (12) de transposition, assurant une troisième transposition en fréquence effectuée dans le domaine analogique, par multiplication dudit signal résultant par ladite fréquence d'émission $\omega_1$, de façon à générer le signal intermédiaire suivant:

* $m'_3(t) = g_3.m(t).\cos(\omega_1 t+\theta_1)$

où $g_3$ est le gain introduit par lesdits moyens (12) de transposition, (13) de filtrage, (14) de conversion analogique/numérique;

- des moyens (13) de filtrage passe-bas, assurant un filtrage dudit signal intermédiaire et générant un signal intermédiaire filtré m'(t) ;
- des moyens (14) de conversion analogique/numérique, permettant de convertir en numérique ledit signal intermédiaire filtré m'(t) ;
- des moyens (15) de calcul desdites imperfections en gain $\Delta g$ et en phase $\Delta\theta$ à partir du signal intermédiaire filtré numérique généré par lesdits moyens de conversion analogique/numérique.

**9.** Emetteur radiofréquence selon la revendication 8, **caractérisé en ce que** lesdits moyens (15) de calcul des imperfections en gain $\Delta g$ et en phase $\Delta\theta$ comprennent:

- des moyens de transformation dudit signal intermédiaire filtré numérique sous la forme :

  * $m'(t) = i'(t).\cos(\omega_0 t) - q'(t).\sin(\omega_0 t)$

et **en ce que** les imperfections en gain $\Delta g$ et en phase $\Delta\theta$ sont estimées selon les formules suivantes :

* $\Delta g = 2g - (4/g_3).[i'(t) + q'(t)].[i(t) - q(t)]$
* $\Delta\theta = (1/g.g_3).[i(t).q'(t)- q(t).i'(t)]$, où $g = \frac{g_1+g_2}{2}$.

**10.** Emetteur radiofréquence selon l'une quelconque des revendications 8 et 9, **caractérisé en ce que** lesdits gains g et $g_3$ possèdent des valeurs en puissance de 2.

**11.** Emetteur radiofréquence selon l'une quelconque des revendications 7 à 10, **caractérisé en ce que** lesdits deux signaux corrigés, à la fréquence intermédiaire et en quadrature, s'écrivent, sous la forme simplifiée suivante :

* $m_{1c}(t) = (1 + (\Delta g/2g)).[i(t).\cos(\omega_0 t - (\Delta\theta/2)) - q(t).\sin(\omega_0 t - (\Delta\theta/2))]$
* $m_{2c}(t) = - (1 - (\Delta g/2g)).[i(t).\sin(\omega_0 t + (\Delta\theta/2)) - q(t).\cos(\omega_0 t + (\Delta\theta/2))]$.

**12.** Emetteur radiofréquence selon l'une quelconque des revendications 6 à 11, **caractérisé en ce que** lesdits moyens (14) de conversion analogique/numérique présentent une fréquence de travail sensiblement identique à la fréquence de travail de moyens ($5_1$, $5_2$) de conversion numérique/analogique compris dans lesdits moyens (2) de conversion directe.

**13.** Emetteur radiofréquence selon la revendication 3 et l'une quelconque des revendications 6 à 12, **caractérisé en ce que** lesdits moyens (10, 11) de compensation numérique sont inclus dans ledit circuit intégré.

**Patentansprüche**

**1.** Funkfrequenzsender, der von zwei digitalen Signalen in Basisband und in 90°-Phasenverschiebung (i(nT), q(nT)) gespeist wird, welche Abbildungen zweier binärer Flüsse sind, die eine zu sendende Information darstellen, **dadurch gekennzeichnet, dass** er folgendes umfasst:

- Mittel (1) zum Versatz nach Zwischenfrequenzen und zur digitalen Bearbeitung, die einen ersten Frequenzversatz im digitalen Bereich bei einer Zwischenfrequenz $\omega_0$ der erwähnten Basisbandsignale sicherstellen und durch Kombinieren zwei bei der Zwischenfrequenz liegende und gegeneinander um 90° phasenverschobene Signale erzeugen;
- direkte Konversionsmittel (2), die einen zweiten Frequenzversatz im analogen Bereich durch Multiplikation ($8_1$, $8_2$) mit einer Frequenz $\omega_1$ sicherstellen, gefolgt von einer Summierung (q) dieser zwei bei der Zwischenfrequenz liegenden und um 90° phasenverschobenen Signale, um ein resultierendes Signal (m(t)) zu erzeugen, das sich am Ende um eine Frequenz $\omega_2$ herum moduliert wieder findet, wobei $\omega_2 = \omega_0 + \omega_1$.

**2.** Funkfrequenzsender nach Anspruch 1,
**dadurch gekennzeichnet, dass** die zwei erwähnten bei der Zwischenfrequenz liegenden und gegeneinander um

90° phasenverschobenen Signale die folgende Form aufweisen:

* $m_1(t)= i(t) \cdot \cos(\omega_0 t) - q(t) \cdot \sin(\omega_0 t)$
* $m_2(t)= -i(t) \cdot \sin(\omega_0 t) - q(t) \cdot \cos(\omega_0 t)$

und dass das resultierende Signal die folgende Form aufweist:

* $m(t) = g_1 \cdot m_1(t) \cdot \cos(\omega_1 t + \theta_1) + g_2 \cdot m_2(t) \cdot \sin(\omega_1 t + \theta_2)$

wobei:

- $g_1$ und $g_2$ die entsprechenden Gewinne der zwei um 90° phasenverschobenen Wege der erwähnten direkten Konversionsmittel sind;
- $\theta_1$ und $\theta_2$ die entsprechenden Phasenverschiebungen der zwei um 90° phasenverschobenen Wege der erwähnten direkten Konversionsmittel sind.

**3.** Funkfrequenzsender nach einem der Ansprüche 1 oder 2,
**dadurch gekennzeichnet, dass** er in Form eines integrierten Schaltkreises realisiert ist.

**4.** Funkfrequenzsender nach einem der Ansprüche 1 bis 3,
**dadurch gekennzeichnet, dass** er außerdem Filtermittel (17) umfasst, die das erwähnte resultierende Signal empfangen und filtern, um zumindest teilweise eine parasitäre Komponente des bei einem Frequenz-Abbild $\omega_2$, der Frequenz $\omega_2$, liegenden resultierenden Signals zu eliminieren.

**5.** Funkfrequenzsender nach einem der Ansprüche 3 oder 4,
**dadurch gekennzeichnet, dass** zumindest ein Teil der erwähnten Filterungsmittel (17) in dem erwähnten integrierten Schaltkreis enthalten ist.

**6.** Funkfrequenzsender nach einem der Ansprüche 1 bis 5,
**dadurch gekennzeichnet, dass** er ferner Mittel (10, 11) zur digitalen Kompensation der Gewinn- und Phasenabweichungen der erwähnten direkten Konversionsmittel umfasst.

**7.** Funkfrequenzsender nach Anspruch 6,
**dadurch gekennzeichnet, dass** die digitalen Kompensationsmittel folgendes umfassen:

- Mittel (10) zum Schätzen der Gewinnabweichungen $\Delta g$ und der Phasenabweichungen $\Delta\theta$ der erwähnten direkten Konversionsmittel, wobei:

    * $\Delta g = g_2 - g_1$
    * $\Delta\theta = \theta_2 - \theta_1$

- Mittel (11) zum Anwenden einer Korrektur auf die zwei erwähnten bei der Zwischenfrequenz liegenden und um 90° phasenverschobenen Signale, um zwei korrigierte bei der Zwischenfrequenz liegende und um 90° phasenverschobene Signale $m_{1c}(t)$ und $m_{2c}(t)$ zu erzeugen, wobei das entsprechende korrigierte resultierende Signal folgendermaßen gechrieben wird:

    * $m_c(t) = g_1 \cdot m_{1c}(t) \cdot \cos(\omega_1 t + \theta_1) + g_2 \cdot m_{2c}(t) \cdot \sin(\omega_1 t + \theta_2)$.

**8.** Funkfrequenzsender nach Anspruch 7,
**dadurch gekennzeichnet, dass** die Mittel (10) zum Schätzen der Abweichungen folgendes umfassen:

- Versatzmittel (12), die einen dritten Frequenzversatz im analogen Bereich sicherstellen, durch Multiplizieren des resultierenden Signals mit der Sendefrequenz $\omega_1$, um das folgende Zwischensignal zu erzeugen:

    * $m'_3(t) = g_3 \cdot m(t) \cdot \cos(\omega_1 t + \theta_1)$

    wobei $g_3$ der von den Versatzmitteln (12), von den Filtermitteln (13) und von den Analog/Digital-Konversionsmitteln (14) eingeführte Gewinn ist;

- Tiefpassfiltermittel (13), die eine Filterung des Zwischensignals sichern und ein gefiltertes Zwischensignal m'(t) erzeugen;
- Analog/Digital-Konversionsmittel (14), welche die Konversion des gefilterten Zwischensignals m'(t) in ein digitales Signal ermöglichen;
- Berechnungsmittel (15) der Gewinnabweichungen $\Delta g$ und der Phasenabweichungen $\Delta\theta$, ausgehend vom gefilterten digitalen Zwischensignal, das von den Analog/Digital Konversionsmitteln erzeugt wird.

**9.** Funkfrequenzsender nach Anspruch 8
**dadurch gekennzeichnet, dass** die Berechnungsmittel (15) der Gewinnabweichungen $\Delta g$ und der Phasenabweichungen $\Delta\theta$ folgendes umfassen:

- Transformationsmittel des gefilterten, digitalen Zwischensignals in der Form:

  * $m'(t) = i'(t) \cdot \cos(\omega_0 t) - q'(t) \cdot \sin(\omega_0 t)$

  und **dadurch**, dass die Gewinnabweichungen $\Delta g$ und die Phasenabweichungen $\Delta\theta$ nach den folgenden Formeln geschätzt werden:

* $\Delta g = 2g - (4/g_3) \cdot [i'(t) + q'(t)] \cdot [i(t) - q(t)]$
* $\Delta\theta = (1/g \cdot g_3) \cdot [i(t) \cdot q'(t) - q(t) \cdot i'(t)]_2$, wobei $g = \frac{g_1 + g_2}{2}$.

**10.** Funkfrequenzsender nach einem der Ansprüche 8 oder 9,
**dadurch gekennzeichnet, dass** die Gewinne g und $g_3$ über Werte in Zweierpotenzen verfügen.

**11.** Funkfrequenzsender nach einem der Ansprüche 7 bis 10,
**dadurch gekennzeichnet, dass** die zwei korrigierten bei der Zwischenfrequenz liegenden und um 90° phasenverschobenen Signale sich in der folgenden, vereinfachten Form schreiben lassen:

* $m_{1c}(t) = (1 + (\Delta g/2g)) \cdot [i(t) \cdot \cos(\omega_0 t - (\Delta\theta/2)) - q(t) \cdot \sin(\omega_0 t - (\Delta\theta/2))]$
* $m_{2c}(t) = -(1 - (\Delta g/2g)) \cdot [i(t) \cdot \sin(\omega_0 t + (\Delta\theta/2)) - q(t) \cdot \cos(wot + (\Delta\theta/2))]$.

**12.** Funkfrequenzsender nach einem der Ansprüche 6 bis 11,
**dadurch gekennzeichnet, dass** die Analog/Digital-Konversionsmittel (14) eine Arbeitsfrequenz aufweisen, die in etwa identisch ist zur Arbeitsfrequenz der in den direkten Konversionsmitteln (2) enthaltenen Digital/Analog-Konversionsmittel ($5_1$, $5_2$).

**13.** Funkfrequenzsender nach Anspruch 3 und einem der Ansprüche 6 bis 12,
**dadurch gekennzeichnet, dass** die digitalen Kompensationsmittel (10, 11) in dem erwähnten integrierten Schaltkreis enthalten sind.

## Claims

**1.** Radiofrequency emitter of the type fed by two digital signals in baseband and in quadrature (i(nT), q(nT)) that are images of two binary fluxes representing information to be transmitted, **characterised in that** it comprises:

- means (1) for intermediate frequency transposition and for digital treatment, providing a first frequency transposition carried out in the digital domain, at an intermediate frequency $\omega_0$, of the said signals in baseband and generating by combination two signals at the intermediate frequency and in quadrature;
- means (2) for direct conversion, providing a second frequency transposition carried out in the digital domain, by multiplication ($8_1$, $8_2$) by a frequency $\omega_1$ followed by a summation (9) of the said two signals at the intermediate frequency and in quadrature, so as to generate a resultant signal (m(t)) that is finally modulated around a frequency $\omega_2$ where: $\omega_2=\omega_0+\omega_1$.

**2.** Radiofrequency emitter according to claim 1, **characterised in that** the said two signals at the intermediate frequency and in quadrature are of the form:

* $m_1(t)=i(t).\cos(\omega_0 t)-q(t).\sin(\omega_0 t)$

- * $m_2(t)=-i(t).\sin(\omega_0 t)-q(t).\cos(\omega_0 t)$

and **in that** the said resultant signal is of the form:

- * $m_1(t)=g_1.m_1(t).\cos(\omega_1 t+\theta_1)+g_2.m_2(t).\sin(\omega_1 t+\theta_2)$

where:

- $g_1$ and $g_2$ are the respective gains of the two channels in quadrature of the said direct conversion means;
- $\theta_1$ and $\theta_2$ are the respective phase shifts of the two channels in quadrature of the said direct conversion means.

**3.** Radiofrequency emitter according to one of claims 1 and 2, **characterised in that** it is in the form of an integrated circuit.

**4.** Radiofrequency emitter according to one of claims 1 to 3, **characterised in that** it additionally comprises filtering means (17) that receive and filter the said resultant signal so as to suppress at least in part a parasite component of the said resultant signal at an image frequency ω.2 of the said frequency $\omega_2$.

**5.** Radiofrequency emitter according to claims 3 and 4, **characterised in that** at least a part of the said filtering means (17) is included in the said integrated circuit.

**6.** Radiofrequency emitter according to any one of claims 1 to 5, **characterised in that** it additionally comprises means (10, 11) for digital compensation of the imperfections in gain and in phase of the said direct conversion means.

**7.** Radiofrequency emitter according to claim 6, **characterised in that** the said digital compensation means comprise:

- means (10) for estimating the imperfections in gain Δg and in phase Δθ of the said direct conversion means, where:
  - * $\Delta g=g_2-g_1$
  - * $\Delta\theta=\theta_2-\theta_1$
- means (11) for applying a correction to the said two signals at the intermediate frequency and in quadrature so as to generate two corrected signals, $m_{1c}(t)$ and $m_{2c}(t)$, at the intermediate frequency and in quadrature, the corresponding corrected resultant signal having the form:
  - * $m_c(t)=g_1.m_{1c}(t).\cos(\omega_1 t+\theta_1)+g_2.m_{2c}(t).\sin(\omega_1 t+\theta_2)$

**8.** Radiofrequency emitter according to claim 7, **characterised in that** the said means (10) for estimating imperfections comprise:

- transposition means (12) providing a third frequency transposition carried out in the digital domain, by multiplying the said resultant signal by the emission frequency $\omega_1$, so as to generate the following intermediate signal:
  - * $m^1{}_3(t)=g_3.m(t).\cos(\omega_1 t+\theta_1)$

  where $g_3$ is the gain introduced by the said transposition means (12), filtering means (13), and analogue/digital conversion means (14);
- low-pass filtering means (13) providing a filtering of the said intermediate signal and generating a filtered intermediate signal m'(t);
- analogue/digital conversion means (14) enabling the said filtered intermediate signal m'(t) to be converted into a digital signal;
- means (15) for calculating the said imperfections in gain Δg and in phase Δθ from the digital filtered intermediate signal generated by the said analogue/digital conversion means.

**9.** Radiofrequency emitter according to claim 8, **characterised in that** the said means (15) for calculating imperfection

in gain $\Delta g$ and in phase $\Delta\theta$ comprise:

- means for transforming the said digital filtered intermediate signal into the form:

  * $m'(t)=i'(t).\cos(\omega_0 t)-q'(t).\sin(\omega_0 t)$

  and **in that** the imperfections in gain $\Delta g$ and in phase $\Delta\theta$ are estimated according to the following formulae:

  * $\Delta g=2g-(4/g_3).[i'(t)+q't)].[i(t)-q(t)]$
  * $\Delta\theta=(1/g.g_3).[i(t).q'(t)-q(t).i'(t)]$, where $g=\frac{g1+g2}{2}$

**10.** Radiofrequency emitter according to either of claims 8 and 9, **characterised in that** the said gains g and $g_3$ have values to the power of 2.

**11.** Radiofrequency emitter according to any one of claims 7 to 10, **characterised in that** the said two corrected signals, at the intermediate frequency and in quadrature, have the following simplified form:

* $m_{1c}(t)=(1+(\Delta g/2g)).[i(t).\cos(\omega_0 t-(\Delta\theta/2))-q(t).\sin(\omega_0 t-(\Delta\theta/2))]$
* $m_{2c}(t)= - (1- (\Delta g/2g)).[i(t).\sin(\omega_0 t+(\Delta\theta/2))-q(t).\sin(\omega_0 t-(\Delta\theta/2))]$

**12.** Radiofrequency emitter according to any one of claims 6 to 11, **characterised in that** the said analogue/digital conversion means (14) have a working frequency that is substantially identical to the working frequency of the digital/analogue conversion means ($5_1$, $5_2$) included in the said direct conversion means (2).

**13.** Radiofrequency emitter according to claim 3 and according to any one of claims 6 to 12, **characterised in that** the said digital compensation means (10, 11) are included in the said integrated circuit.

FIG. 1

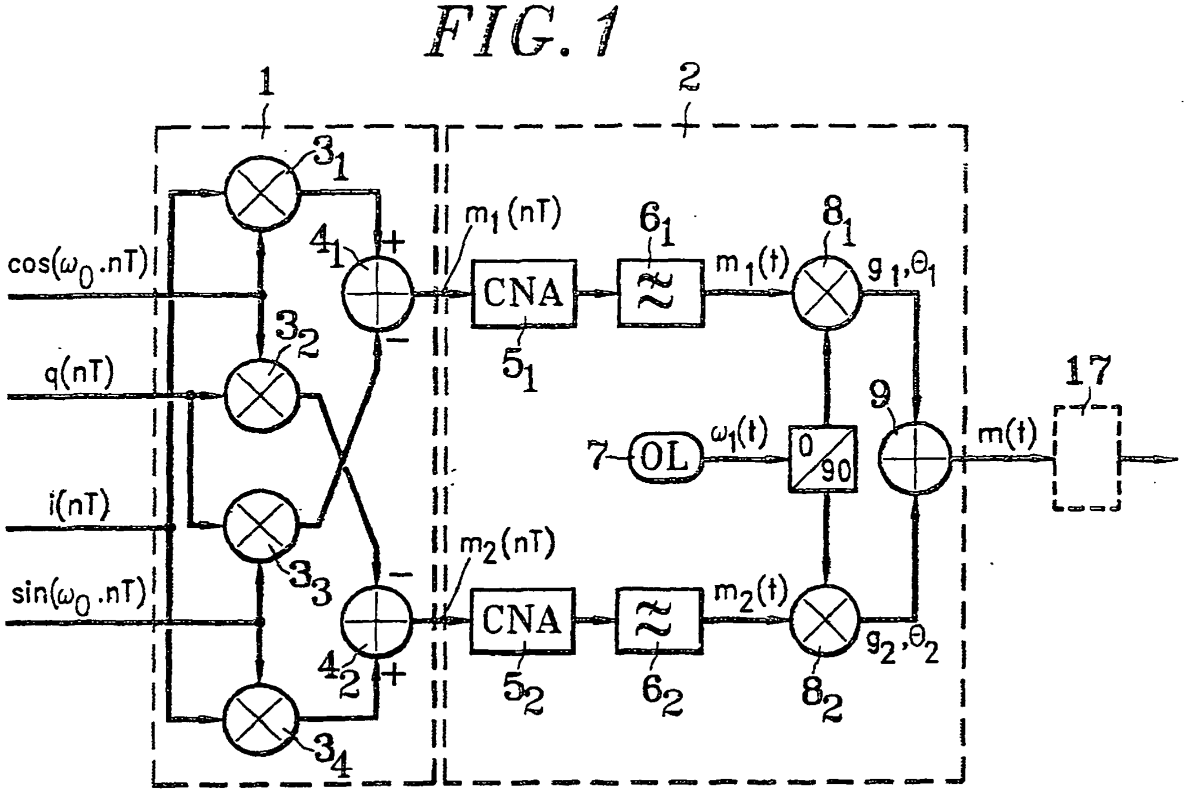
1
2
cos(ω0.nT)
q(nT)
i(nT)
sin(ω0.nT)
31
32
33
34
41
42
+
-
m1(nT)
m2(nT)
CNA
51
52
61
62
m1(t)
m2(t)
81
82
g1,θ1
g2,θ2
7
OL
ω1(t)
0
90
9
m(t)
17

FIG. 2

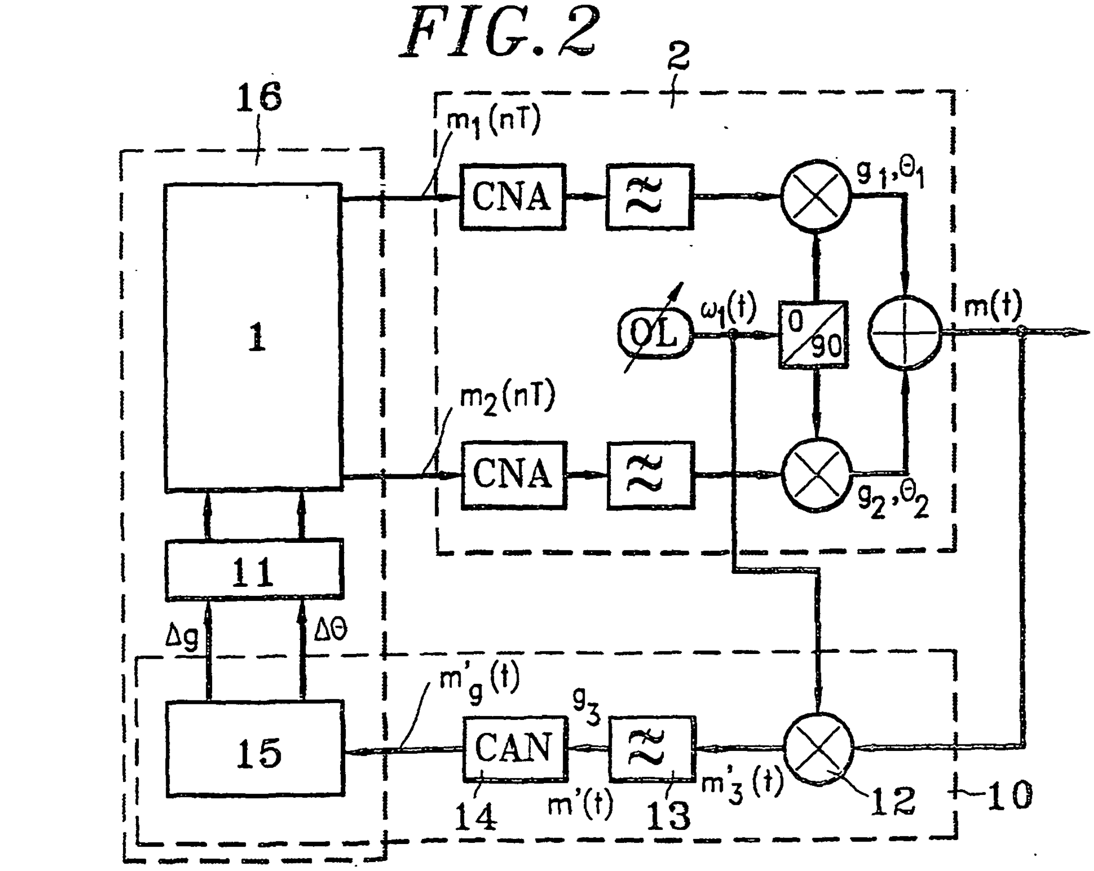
16
2
1
11
Δg
ΔΘ
15
m1(nT)
m2(nT)
CNA
OL
ω1(t)
0
90
g1,θ1
g2,θ2
m(t)
m'g(t)
g3
CAN
14
m'(t)
13
m'3(t)
12
10